# EUROPEAN PATENT SPECIFICATION

(11) **EP 3 446 219 B1**
(45) Date of publication and mention of the grant of the patent: **09.11.2022**
(21) Application number: 17786742.1
(22) Date of filing: 21.04.2017
(51) Int. Cl.: G06F 16/174, G06F 15/16, H03M 7/30, H03M 7/34

(54) **SYSTEM AND METHOD FOR ENHANCING DATA HANDLING IN A NETWORK ENVIRONMENT**
SYSTEM UND VERFAHREN ZUR VERBESSERUNG DER DATENHANDHABUNG IN EINER NETZWERKUMGEBUNG
SYSTÈME ET PROCÉDÉ D'AMÉLIORATION DE LA MANIPULATION DES DONNÉES DANS UN ENVIRONNEMENT DE RÉSEAU

(30) Priority: 22.04.2016 US 201662326428 P; 16.01.2017 US 201715407192
(43) Date of publication of application: 27.02.2019
(73) Proprietor: Vertigo Media, Inc., Charlotte, NC 28277 (US)
(72) Inventor: SAVENOK, Alexander, Grandview MO 64030 (US); SAVENOK, Pavel, Wheaton IL 60189 (US); LEEKLEY, Gregory, H., Charlotte NC 28277 (US)
(74) Representative: Gorman, Francis Fergus
(86) International application number: PCT/US2017/028908
(87) International publication number: WO 2017/185014

(56) References cited:
- WO-A1-2015/164613
- US-A1- 2002 188 745
- US-A1- 2003 216 958
- US-A1- 2006 184 652
- US-A1- 2008 181 498
- US-A1- 2011 173 214
- US-A1- 2011 225 417
- US-A1- 2012 239 647
- US-A1- 2014 006 559
- US-A1- 2014 044 191
- US-A1- 2014 164 563
- US-A1- 2015 293 934
- US-A1- 2016 085 499
- US-A1- 2016 099 990
- US-A1- 2016 173 557
- US-B1- 6 513 050
- US-B1- 8 656 020
- US-B2- 7 640 363
- US-B2- 8 074 241
- US-B2- 8 074 241
- Jeff Herbert ET AL: "A Novel Method for Decentralised Peer-to-Peer Software License Validation Using Cryptocurrency Blockchain Technology", , 27 January 2015 (2015-01-27), XP055358639, Retrieved from the Internet: URL:http://crpit.com/confpapers/CRPITV159H erbert.pdf [retrieved on 2017-03-24]
- Motoki Kitahara ET AL: "A method of digital rights management based on Bitcoin protocol", Proceedings of the 8th International Conference on Ubiquitous Information Management and Communication, ICUIMC '14, 31 January 2014 (2014-01-31), pages 1-6, XP055403712, New York, New York, USA DOI: 10.1145/2557977.2558034 ISBN: 978-1-4503-2644-5

## Description

### PRIOR HISTORY

This U.S. patent application claims the benefit of pending U.S. Provisional Patent Application Serial No. 62/326,428 filed in the United States Patent and Trademark Office (USPTO) on 22 April 2016, and is a Continuation-in-Part patent application of co-pending U.S. Patent Application Serial No. 15/407,192 filed in the USPTO on 16 January 2017.

### FIELD OF THE INVENTION

The present invention generally relates to mobile application features or software tools interoperable or cooperable by way of networked computers as typified by networked mobile communications devices for implementing the mobile application features or software tools and providing for a reduction in stored data redundancy at server locations within the network, and enhanced data transmissions intermediate sending and receiving clientele. More particularly, the mobile application features or software tools according to the present invention enable users to share and consume in real time user-selected or user-generated content while simultaneously sharing and consuming media content while reducing data redundancy in digital storage and enhancing data transmissions so as to maximize the efficiency of the system and associated methods.

### BACKGROUND ART

U.S. Patent Application Specification No. 2006/0184652 of Teodosiu et al., discloses applications for the remote differential compression of files in a computing environment using a remote differential compression algorithm. Remote differential compression is integrated within the applications. When objects are updated between two or more computing devices using remote differential compression techniques, data transfers are minimized between the two or more computing devices. The remote differential compression algorithm provides enhanced efficiencies for allowing a receiver of an updated object to locate a set of objects which are similar to the updated object that is being transferred from a sender to the receiver. Once this set of similar objects has been found, the receiver may reuse any portions from these similar objects during execution of the remote differential compression algorithm to recreate the updated object.

U.S. Patent Application Specification No. 2015/0293934 of Huang discloses a system which is configured to store differences between precompressed and recompressed data files. The system comprises a processor and a memory. The processor is configured to decompress a precompressed file; recompress the decompressed file; and determine a data difference file. The memory is coupled to the processor and is configured to provide the processor with instructions.

U.S. Patent Application Specification No. 2008/0181498 of Swenson et al., discloses a system and a method for communicating video data associated with content across a network. A server partitions the content into a plurality of tiles where each tile includes a subset of the content and index data describing a relationship between a tile and one or more adjacent tiles. Each tile is then encoded as a video frame. The plurality of tiles are then transmitted to a client which combines the plurality of tiles using the index data to locally recreate the content.

U.S. Patent Application Specification No. 2002/0188745 of Hughes et al., discloses a system and method for distributing media files, such as audio or video files, to devices for playback or streaming at various quality levels. Hughes discloses a method in which a stacked media file is provided which has low, medium and high quality information for the same content. The file is transmitted to a receiving device at the highest quality level that the receiving device can decode. The hierarchy of the media file is such that data redundancies are avoided by, for example, stacking the data within the file in such a way that the data is segregated into data sets corresponding to a given sampling rate, with each successive data set containing only those data points not found in the preceding data set.

U.S. Patent Application Specification No. 2012/0239647 of Savenok et al., discloses a system and method for custom marking a media/ audio file for file matching. A file-identifying fingerprint or marker is associated with a media/audio file after waveform values are extracted from the media/audio file, via certain data extraction and/or audio analysis routines. The extracted waveform values are statistically manipulated so as to render an array of statistical values for the analysed media/audio file, which are then compiled to form the custom marker, and embedded within the metadata of the media/audio file which results in the marking of the media/audio file. The custom marker or fingerprint can then be matched against a set of reference fingerprints stored in a database, to determine the identity of the signal or the similarity between two signals.

U.S. Patent Specification No. 8,074,241 of Arfidsson et al., discloses a method and user interface for streaming panoramic video and images between a server and a browser based client application.

### SUMMARY OF THE INVENTION

The systems and methods here presented for consideration comprise several primary areas of concern, including the following general topics: PCM Patching; PCM Storage; Base File Matching; PCM Difference Data Playback; Multi-port Data Delivery; 360 Video Delivery; and Video-Music Synchronization. The PCM patching or handling aspects of the present systems and methods according to independent Claims 1 and 9, respectively, are believed central to the present specifications and primarily operate to reduce redundant PCM data within a storage system focused on storing PCM related content. The invention is defined by the independent claims. Additional features of the invention are provided in the dependent claims.

### BRIEF DESCRIPTION OF THE DRAWINGS

Other objects of the present invention, as well as particular features, elements, and advantages thereof, will be elucidated or become apparent from, the following brief descriptions of drawing figures submitted in support of these specifications.
Figure No. 1A is a simplified diagrammatic depiction of side-by-side first and second data files depicting the first data file being of a different size and shape as compared to the second data file.
Figure No. 1B is a simplified diagrammatic depiction of side-by-side first and second data files placed into a data file storage mechanism depicting the first data file and the second data file each having significantly sized and shaped portions of a similar or highly redundant size and shape.
Figure No. 2A is a simplified diagrammatic depiction of side-by-side first and second data files being compared for determining (a) those aspects of the first data file that are differently sized and shaped as compared to the second data file, and (b) those aspects of the first data file that are similarly or redundantly sized and shaped as compared to the second data file.
Figure No. 2B is a simplified diagrammatic depiction of showing a data (size and shape) difference between the first and second data files.
Figure No. 2C is a simplified diagrammatic depiction of those similarly sized and shaped data file elements represented as a single square shape and the data difference between the first and second data files represented as a triangle being placed into the data file storage mechanism otherwise depicted in Figure No. 1B comparatively depicting a reduction in data redundancy relative thereto.
Figure No. 3 is a flowchart diagram depicting a Pulse Code Modulation or PCM patching system and process according to the present invention.
Figure No. 4 is a flowchart diagram depicting a data storage system and process according to the present invention.
Figure No. 4A is a flowchart diagram depicting a first alternative data retrieval/return system and process according to the present invention.
Figure No. 4B is a flowchart diagram depicting a second alternative data retrieval/return system and process according to the present invention.
Figure No. 5 is a flowchart diagram depicting a base file mapping system and process according to the present invention.
Figure No. 6 is a flowchart diagram depicting a PCM data difference playback system and process according to the present invention.
Figure No. 7 is a flowchart diagram depicting a sending client and a receiving client each outfitted with a multi-port data transmission arrangement according to the system and process of the present invention.
Figure No. 8 is a flowchart diagram depicting a receiving client outfitted with a multi-port data transmission arrangement according to the system and process of the present invention and selectively (a) merging (1) base quality frame data transmitted via a base quality port with either (i) mid-quality frame data transmitted via a first secondary port or (ii) high quality frame data transmitted via a second secondary port and (b) outputting either (1) a mid-quality frame for playback or (2) a high quality frame for playback.
Figure No. 9 is a diagrammatic perspective depiction of a viewpoint marked with a black dot and showing objects located in 90 degree intervals relative to the viewpoint.
Figure No. 10 is a diagrammatic perspective depiction of the viewpoint enlarged to show an internal cube with a first face of the internal cube highlighted in bold lining with a depiction of a corresponding spherical surface area.
Figure No. 11 is a diagrammatic perspective depiction of the scene otherwise depicted in Figure No. 9 with the internal cube superimposed at the original viewpoint with a series a cube faces opposing each of the objects in the scene.
Figure No. 12 is a diagrammatic net depiction of the scene otherwise depicted in Figure Nos. 9 and 11 as seen from the original viewpoint.

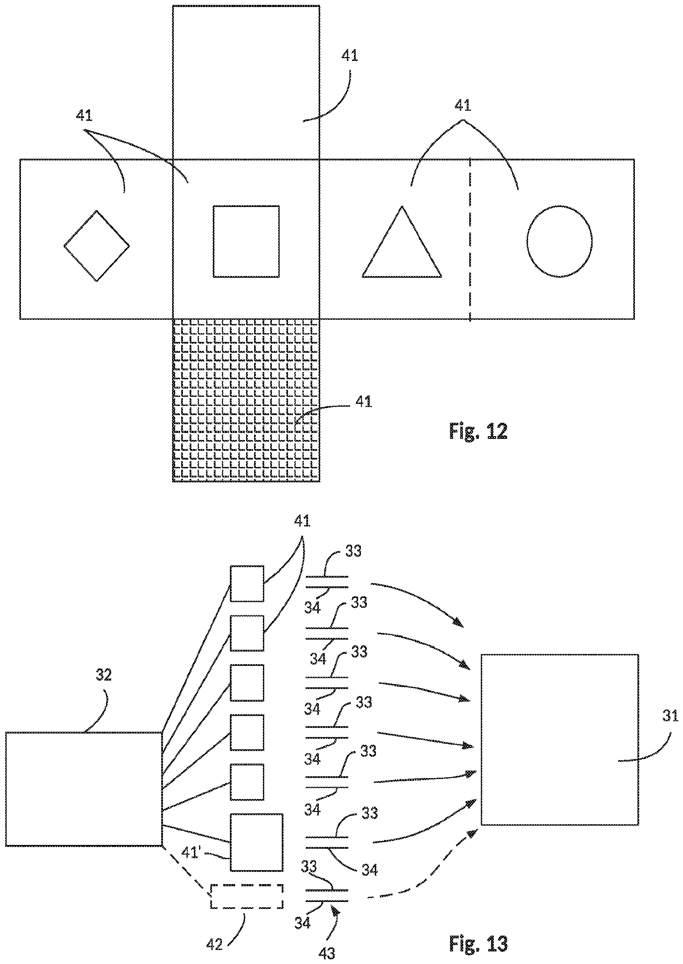

Figure No. 13 is a flowchart diagram depicting a sending client and a receiving client with cube mapping data being transmitted therebetween, the cube mapping data comprising data for each cube face of a cube mapping protocol, the data for each cube face being transmitted via a multi-port arrangement including a base quality port and at least one secondary, higher than base quality port, a select cube face being enlarged in size relative to other cube face depictions to depict a first alternative combination video-audio transmission channel and a broken rectangle to depict a second alternative separate audio transmission channel.

### DETAILED DESCRIPTION OF THE PREFERRED SYSTEM AND METHODOLOGY

Referencing the drawings now with more specificity, the present invention firstly and basically provides a Pulse Code Modulation or PCM patching or handling system and method. PCM patching is very basically a computer-implemented, application-based system supported by associated algorithms to reduce redundant PCM data within a digital storage system focused on storing PCM related content. A generic PCM storage facility is diagrammatically depicted and referenced at 20 in the several drawings submitted in support of these descriptions.

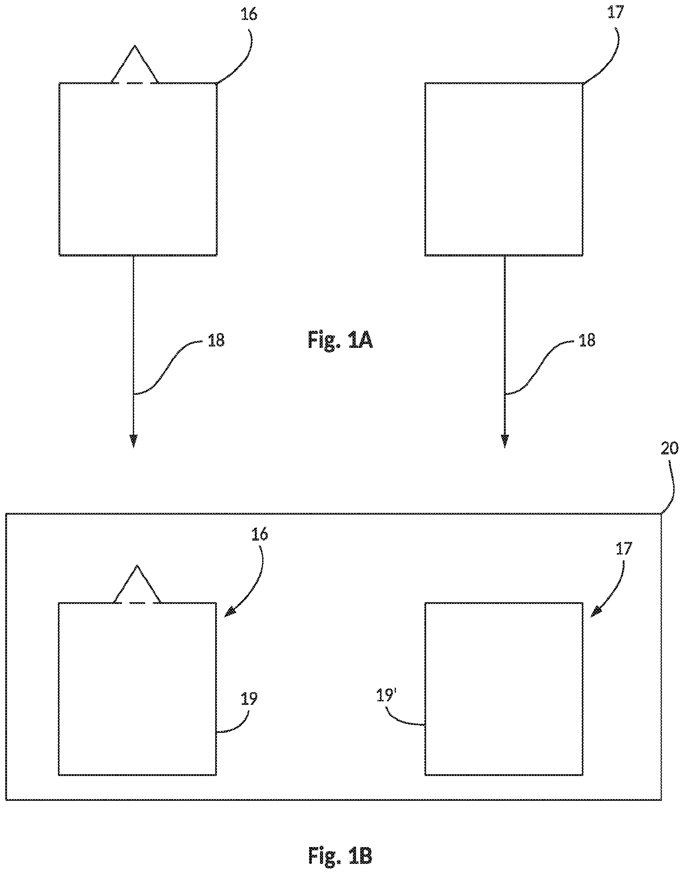

Comparatively referencing Figure Nos. 1A and 1B, the reader will there consider a diagrammatically simplified first PCM data file as at 16, a diagrammatically simplified second PCM data file as at 17, and a diagrammatically simplified PCM data storage system 20. When the first and second PCM data files 16 and 17 are placed into the storage system 20 as at arrow(s) 18, the reader will there comparatively see that the first and second PCM data files 16 and 17 together comprise a significant amount of overlapping data as depicted by the square portions elements as at 19 and 19' of the two PCM data files 16 and 17. Square portion or element 19' may thus be viewed as redundant in view of square portion or element 19.

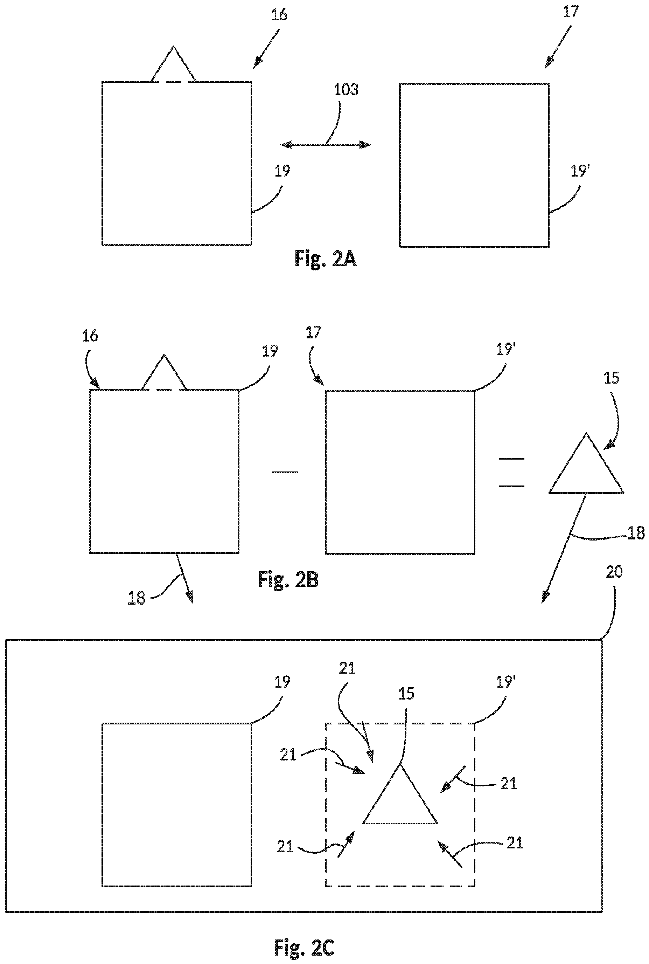

Comparatively referencing Figure Nos. 2A - 2C, the reader will there again consider a diagrammatically simplified first PCM data file 16, a diagrammatically simplified second PCM data file 17, and a diagrammatically simplified PCM data storage system 20. According to the core precepts of the data patching/handling aspects of the present invention, the first PCM data file 16 and second PCM data file 17 are preferably compared as at PCM data comparison process 103, during which process 103 redundant portions (as diagrammatically depicted at square portion 19') are determined and a PCM data difference 15 is output. A basal PCM data portion (as diagrammatically depicted at square portion 19) and the PCM data difference 15 may thus be placed into the data storage system 20 as at arrow(s) 18. Further comparing Figure No. 1B versus Figure No. 2C, the reader will there see that data redundancy has been reduced in Figure No. 2C as compared to Figure No. 1B which redundancy reduction is diagrammatically depicted and referenced at arrow(s) 21.

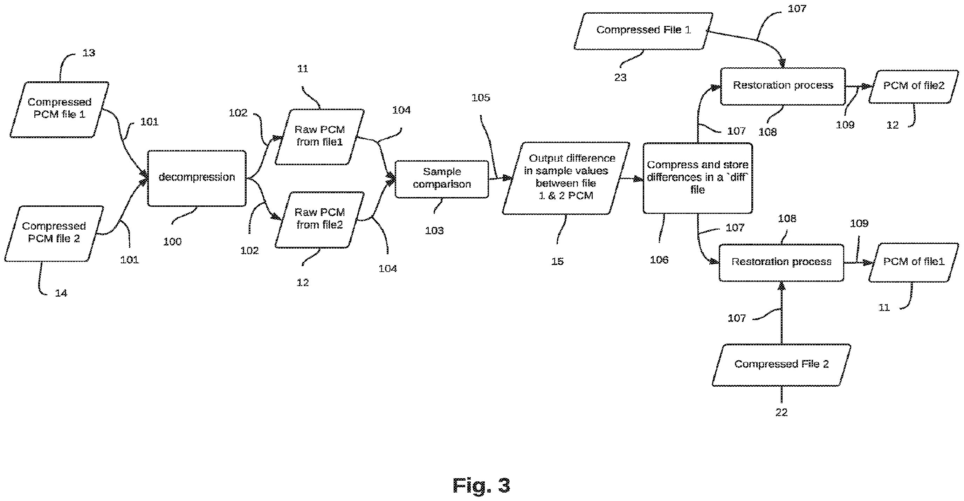

The PCM patching system and method according to the present invention thus require or are operable in combination with at least first and second media (audio) files for comparison purposes. The first and second media files are preferably stored as either raw PCM data or in a compressed form that decode to PCM data. A first raw PCM data file reflective of a first audio file is depicted and referenced at 11, and a second raw PCM data file reflective of a second audio file is depicted and referenced at 12 in Figure No. 3. Further referencing Figure No. 3, the reader will there also consider a first compressed PCM data file reflective of the first audio file as depicted and referenced at 13, and a second compressed PCM data file reflective of the second audio file as depicted and referenced at 14.

The PCM patching system and method according to the present invention may thus be said to preferably comprise a non-transitory, computer-implementable decompression application or decompression appliance for decompressing as at process 100 inputting 101 compressed first and second PCM data (audio) files 13 and 14. The compressed first and second PCM data (audio) files 13 and 14, being decompressed via the decompression appliance diagrammatically referenced at process 100, may be output 102 as the first and second raw PCM data files 11 and 12 as generally and preliminarily depicted at the beginning portions of the flowchart presented in Figure No. 3.

The decompressed output PCM samples or data files 11 and 12 are then compared as at sample comparison process 103 via a non-transitory, computer-implementable PCM data comparison application believed central to the practice of the present invention. The non-transitory, computer-implementable PCM data comparison application is operable to (a) compare input 104 first and second PCM data files 11 and 12 respectively associated with first and second media or audio files; (b) calculate a PCM data difference 15 between the input first and second PCM data files 11 and 12, and (c) output 105 the calculated PCM data difference 15 between the first and second PCM data files 12 and 13 as a data difference file.

A non-transitory, computer-implementable PCM data compression application according to the present invention may then operate to both (a) compress the output calculated data difference 15 or data difference file and (b) store the compressed output calculated data difference 15 or data difference file in the data storage facility 20, which process(es) are denoted at process box 106. In data files that have very similar PCM data, for instance, if a file comparison were performed on the same audio track compressed to 256 kbs and 224 kbs, the difference between PCM values would be slight and indicative of high redundancy. Given a high degree of redundancy, standard compression algorithms can be applied so as to reduce the size of the data difference 15 or date difference file to 60 - 70% of the original compressed file size. The data difference 15 is preferably stored as a data difference file as passed through a compression algorithm as at process 106.

The data difference file or "diff' file 15 can then be used to losslessly reproduce the PCM data of either the first or second earlier compared media (audio) files. The PCM patching system and method according to the present invention may thus be said to further and preferably comprise a non-transitory, computer-implementable PCM data restoration application operable to losslessly reproduce a select PCM data file as selected from the group consisting of the first and second PCM data files 11 and 12 by way of the compressed output calculated data difference 15 or data difference file.

In this regard, the PCM data restoration application is operable to losslessly reproduce or output 109 via a restoration process 108 (a) the first PCM data file 11 via input 107 (i) compressed second (audio) file data 22 and (ii) the compressed output calculated data difference 15 or data difference file and (b) the second PCM data file 12 via input 107 (i) compressed first (audio) file data 23 and (ii) the compressed output calculated data difference 15 or data difference file as generally depicted in Figure No. 3. The PCM patching system and method according to the present invention typically enables a 60 - 70% size reduction of the original compressed file, while further providing the ability to losslessly reproduce the PCM data of the original files.

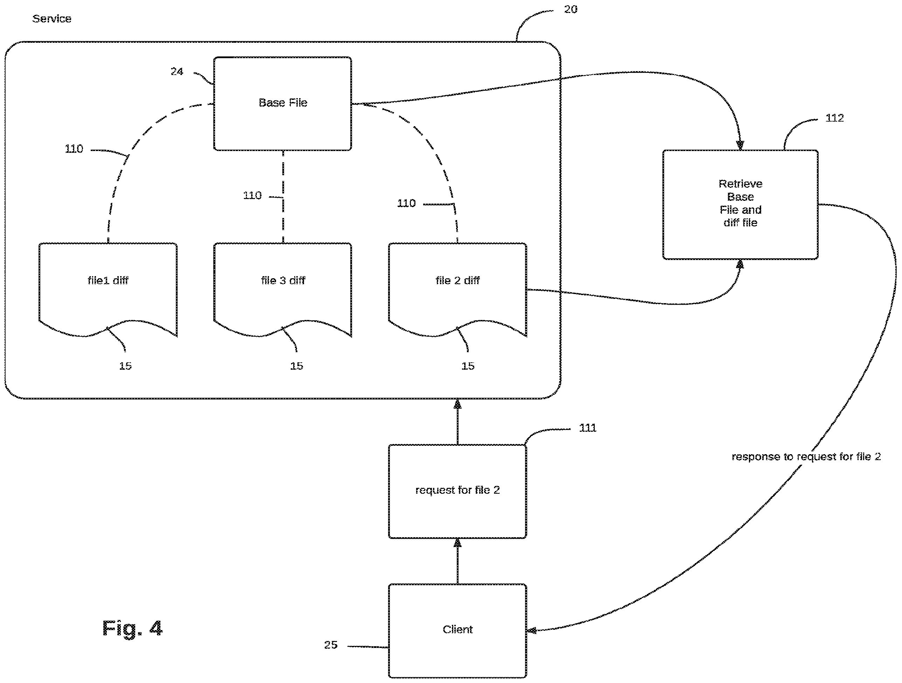

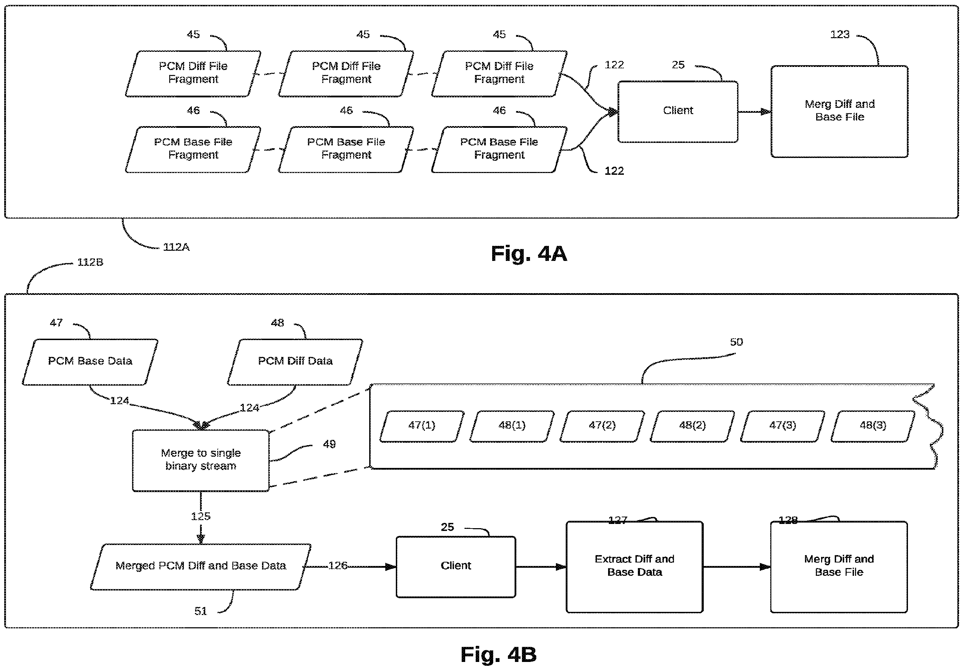

The storage system or mechanism 20 according to the present invention preferably maps 110 base file data 24 to data difference file data 15. A data difference file 15 stores the difference in PCM data between the base file 24 and the originally uploaded media (audio) file. Referencing Figure No. 4, the originally uploaded file may be referenced as "file 2". On request 111 from a compatible client 25, the storage system 20 returns as at generic process 112 both (a) the base file data 24 and (b) "file 2 diff' data 15. The client 25 then uses the collection of data to re-produce the PCM data of the original file. The retrieval or return process 112 may operate by way of a number of different mechanisms, including the following exemplary mechanisms, as denoted at 112A and 112B in Figure Nos. 4A and 4B, respectively.

A first exemplary retrieval mechanism or process 112A according to the present invention provides for fragmentation of all "diff' files or data difference files 15 into smaller "diff' file fragments 45 deliverable as at process 122 to the client 25 incrementally to incrementally patch the PCM data before it is reproduced. Referencing Figure No. 4A, the reader will there consider process retrieval/return mechanism 112A depicting PCM "diff" file fragments 45 and PCM base file fragments 46 delivered 122 to the client 25 outfitted with a non-transitory computer-implementable application to merge the PCM "diff' file and base file fragments 45 and 46 as at process 123.

A second exemplary retrieval/return mechanism 112B according to the present invention returns PCM base data 47 and PCM "diff' data 48 in a single binary stream 49, mixing or merging (as at segment-merged data chain 50) the input 124 PCM "diff" data 48 with PCM base file data 47 in consistent and alternating intervals as in Figure No. 4B. For example, the first 100 kb of the binary stream represents the first segment 47(1) of the PCM base file 47, while a successive 100 kb represents the first segment 48(1) of the PCM "diff" file 48. The system thus alternates between PCM base and "diff" data segment(s) 47/48 delivery every 100 kb and outputs 125 as a merged PCM "diff' and base data stream 51 comprising the segment-merged PCM data chain 50 deliverable 126 to the client 25 where PCM "diff" and base data 47 and 48 may be extracted as at process 127 and re-merged as at process 128. Other methods for delivering the data in a single binary data stream are possible.

The PCM patching or handling system and method according to the present invention thus provide for lossless restoration of a select PCM data file as initiated via a client 25 requesting 111 a select data file from server-based data file storage 20. A base data file 24 and a corresponding compressed output calculated data difference file 15 are returned 112 to the client 25 from the server-based data file storage 20. PCM data of the requested select data file are re-produced at the client 25 via the computer-implemented, non-transitory data restoration application generally depicted and referenced at process 108. The compressed calculated data difference file data 15 may be fragmented and delivered to the client 25 incrementally to incrementally patch file-representative PCM data while being re-produced, or PCM data may be returned in a single binary stream such that base file data and the compressed output calculated data difference file data are mixed and delivered in consistent and alternating intervals as at segment-merged data chain 50.

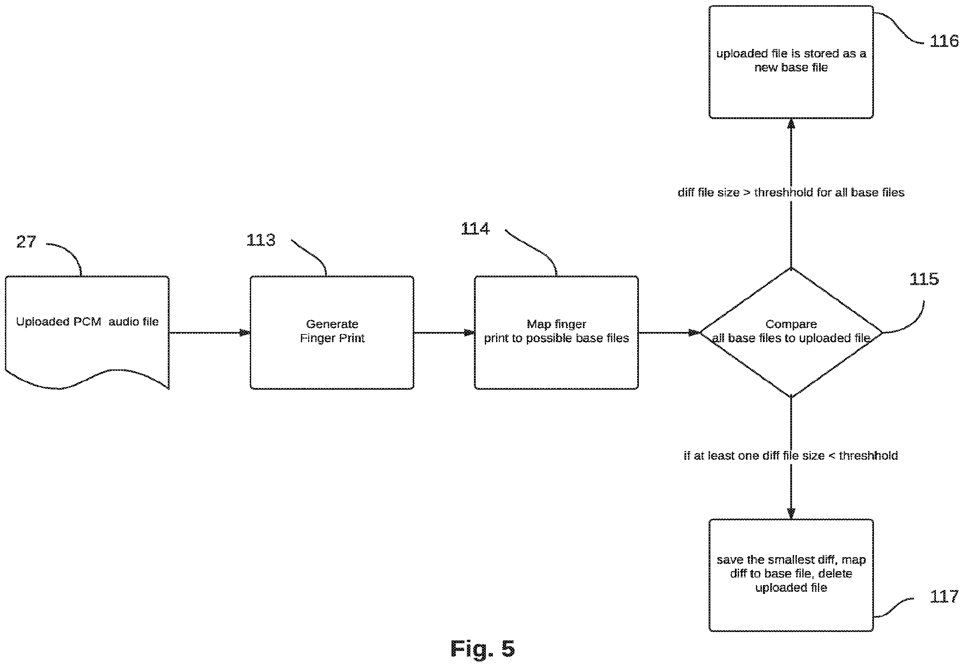

Referencing Figure No. 5, the reader will there consider that before the system and/or method stores and generates data difference files or "diffs" 15 off of base files, the system or method first maps 114 the data difference files or "diffs" 15 to possible matches via a media or audio file fingerprinting (identifying) mechanism/application as at process 113. All base files that have similar fingerprints or file-identifying characteristics to the uploaded file are possible base file candidates. To identify the optimal base file, the system and method generate "diffs" off of all base files; and compare each "diff" size to an established threshold value as at query process 115. If all "diffs" exceed the threshold value, the uploaded file 27 becomes a base file as at path process 116. If one or more "diffs" are determined to be below the threshold value, the "diff" file of least value is stored, and the original file is deleted as at path process 117.

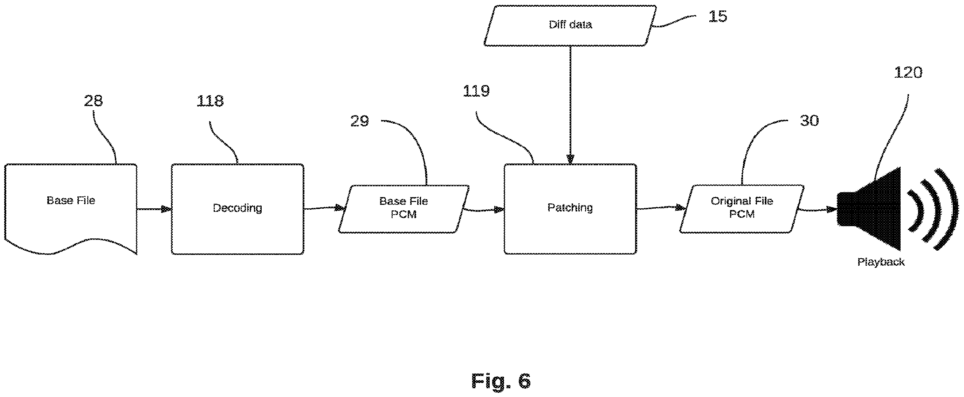

Referencing Figure No. 6, it will be seen that media or audio playback for the "diff" system and method according to the present invention requires the following steps (a) decoding a base file 28 to PCM data 29 via decoding process 118; (b) patching the base file PCM data 29 with data from the "diff" file 15 via patching process 119 thereby forming patched PCM data output 30 (i.e. original file PCM); and (c) sending the patched PCM data output 30 or original file PCM for media/audio playback as at playback process 120. File playback 120 according to the present system and method is thus accomplished by decoding a base file to base file PCM; patching the base file PCM with calculated PCM data difference file data to form an original PCM file; and sending the patched base file PCM for playback as the original PCM file.

It is noted that many real-time protocols rely on Secure Real-time Transport Protocol or SRTP and that quality adjustments are typically made by calls back to the sending device to ensure a consistent quality. This method, however, tends to result in lower overall quality transmissions, since (i) the slowest client will often determine or dictate the quality transmitted to all clients, and (ii) the sending device will adjust the quality based on the ability of the receiving client(s) to receive and process data in time.

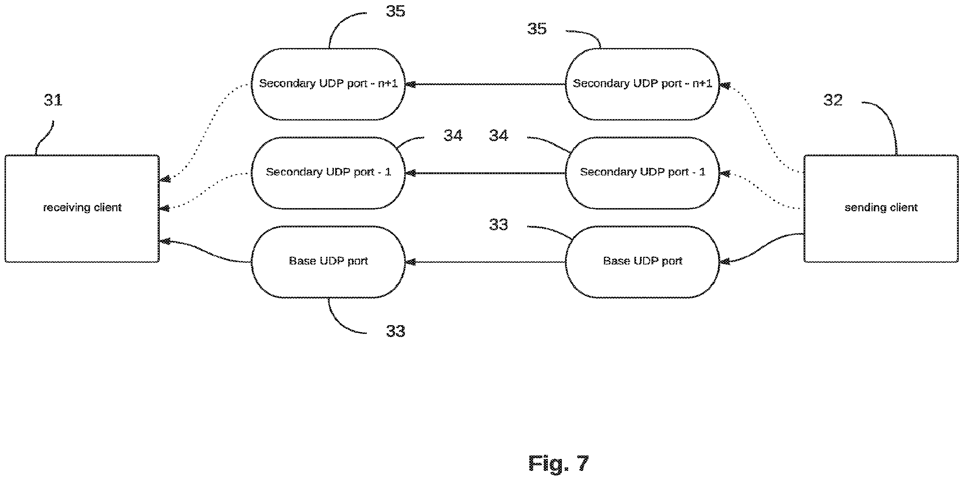

To remedy these shortcomings, the system and method according to the present invention rely on multiple Transmission Control Protocol (TCP) or User Datagram Protocol (UDP) ports for video/audio data transmission as generally depicted and referenced in Figure No. 7. Referencing Figure No. 7, it will be seen that a receiving client and a sending client are there depicted as at 31 and 32, respectively. Each of the receiving client 31 and the sending client 32 according to the present system and method is outfitted or configured with multiple TCP or UDP port capability, including a basal or primary TCP or UDP port arrangement as at 33, and at least one higher than basal or secondary TCP or UDP port arrangement as at 34 and/or 35.

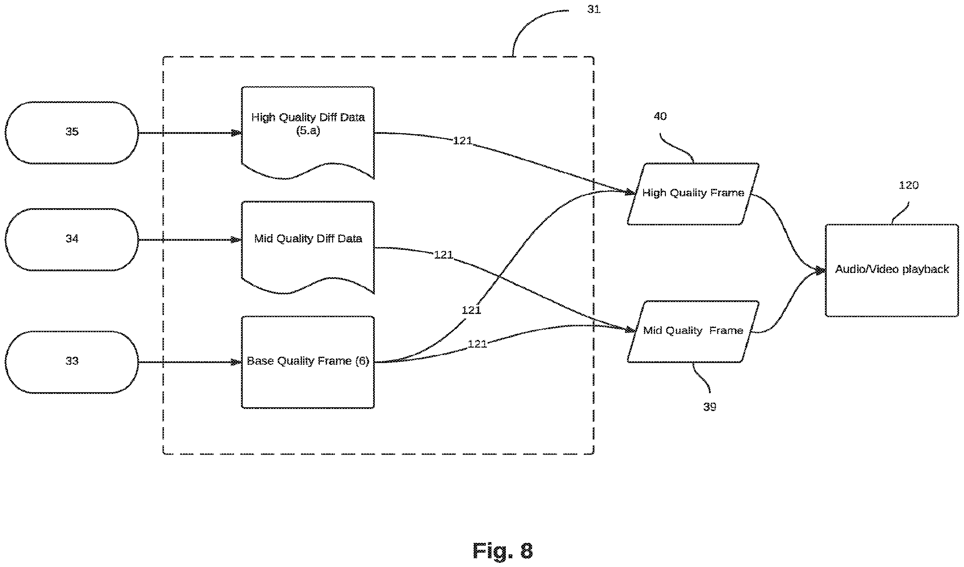

The primary or basal TCP or UDP port(s) 33 are dedicated to base quality transmission via which the broadcasting client 32 sends and the receiving client 31 receives the lowest available quality data transmission. The system further dedicates at least one, but preferably multiple additional or secondary TCP or UDP ports as at 34 and/or 35 via which additional (higher or better than basal) data may be transmitted. The additional TCP or UDP port mechanisms as at 34 and 35, in combination with the basal TCP or UDP port(s) 33, are thus used to increase the quality of base data transmissions. Data transmissions via TCP or UDP ports 34 and/or 35 are preferably sent as "diff' data 36 or 37 of the base quality data 38 as further comparatively referenced in Figure No. 8.

Referencing Figure No. 8, the reader will there consider that the receiving client 31 combines as at process(es) 121 "diff' data of either a mid-quality "diff' data 36 or high-quality "diff' data 37 via either of the secondary TCP or UDP ports 34 or 35 with the base data 38 of the primary or basal TCP or UDP port 33, to produce higher than basal quality media as at 39 or 40 for audio/video playback as at 120. The "diff' data as at 36 or 37 and base data 38 are preferably synchronized via either time stamp methodology or via binary hash methodology of either audio or video frame (exemplified by CRC-64 or MD5). The binary hash is attributed to the "diff' data 36 or 37 and generated off of the base data 38. This type of system allows the sending client 32 to send higher quality data as it is able, since only the base file data 38 are required to maintain the session. Further, the system allows the receiving client 31 to listen and receive as it is able on the secondary ports 34 and/or 35 if it is able to receive a broadcast of higher quality.

File data are thus preferably transmitted via the system and method according to the present invention intermediate a sending client 32 and a receiving client 31 via at least two TCP or UDP ports, including a basal TCP or UDP port 33 of the at least two TCP or UDP ports being dedicated for base quality transmission and at least one secondary TCP or UDP port as at 34 or 35 of the at least two TCP or UDP ports being dedicated for data difference file data transmission. The base quality and data difference file data transmissions are synchronized at the receiving client 31 for producing higher than basal quality output. The base quality and data difference file data transmissions may be preferably synchronized at the receiving client 31 via either a timestamping mechanism, or a binary hash mechanism, the binary hash mechanism being attributed to the data difference file data as generated from the base quality data.

The following descriptions explain how the progressive and adaptive quality mechanisms described above may be utilized to lower latency with high quality real time 360 video transmissions further contemplated by the present system and method as an aspect stemming from the multi-port data transmission ports hereinabove discussed. Noting that 360 degree video playback may occur via several image-stitching methods, the present system and method preferably contemplates usage of cube-mapping methods for producing 360 videos. The cube mapping format according to the present invention sends a unique frame for every cube face 41 of a cubic viewpoint as at 40, and thus for a 360 video, the system and method contemplates six unique frames per 360 degree image as at cube faces or frames 41.

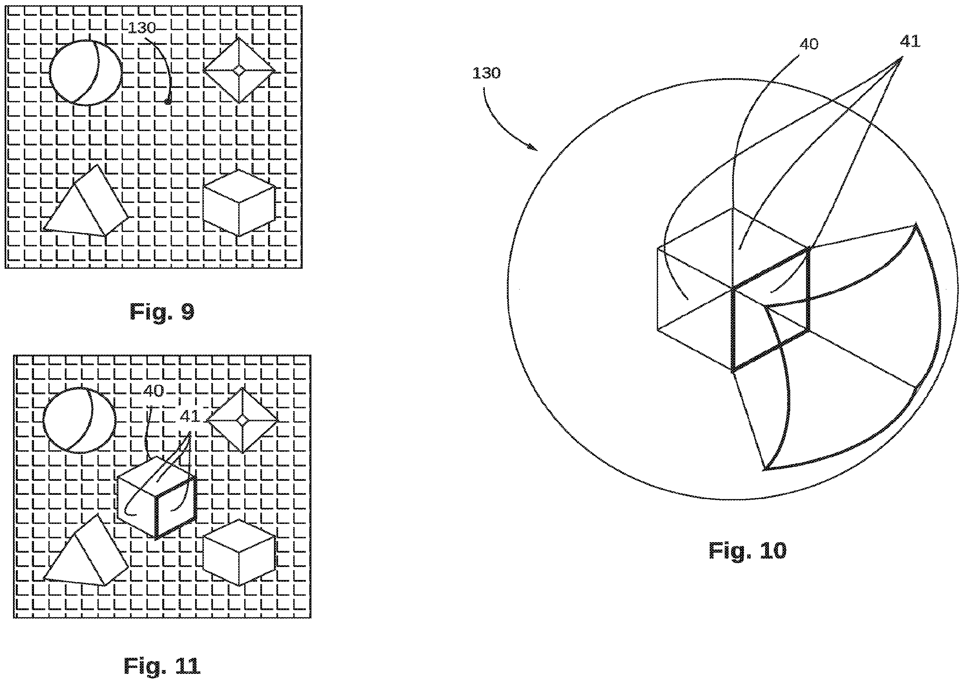

While images of this sort are typically sent in a single data stream, the system and method according to the present invention send each face or frame 41 of the cube 40 along a unique data stream comprising a dedicated multi-port set of TCP or UDP ports, including a basal or primary TCP or UDP port 33 and a secondary or base-plus TCP or UDP port as at 34 or 35. Referencing Figure Nos. 9 and 10, the reader will there consider viewpoint 130. Referencing Figure No. 10, the highlighted cube face 41 represents a single view of the cubic viewpoint 40. Each single view associated with a cube face 41 has a dedicated multi-port set of TCP or UDP ports, including a base quality or primary TCP or UDP port 33, and additional secondary TCP or UDP ports as at 34 or 35 for added quality as described above.

The added secondary TCP or UDP ports as at 34 and/or 35 transmit "diff' data 36 or 37 of the base quality data 38 preferably corresponding with medium/high quality data. The non-transitory, computer-implementable client application at receiving client 31 determines whether to utilize only the base quality data, or whether to add higher quality data based on which direction the viewer is pointed or which cube face 41 is in play. This means that the receiving client 31 is able to constantly stream all faces or frames 41 of the cube 40 at base quality to ensure that frames are loaded as the viewer changes perspective. Additional quality data may be added to ensure that the view currently visible to the user is at the highest possible quality. This methodology further enhances a high quality view it being noted that high quality data need only be delivered for a select few of the cube faces or frames 41 as opposed to all six faces or frames 41 of the cube 40.

Since all data in a 360 video is transmitted on different ports according to the system and method of the present invention, a select data stream may be preferably dedicated to further contain audio data transmissions whereby a select face or frame 41 and an audio stream are combined and transmitted via a TCP or UDP basal port and secondary port set as diagrammatically depicted at relatively larger square 41' in Figure No. 13. The stream containing audio data is used to align music as preferably synchronized and/or reproduced using methods discussed in greater detail within the specifications set forth in US patent application serial number 15/407,192 ('192 Application). An alternative method of audio data transmission is to deliver an audio data packet 42 on a separate dedicated TCP or UDP multi-port set as at 43 in Figure No. 13. Either method may operate in cooperation with the methods otherwise described in the '192 Application.

The PCM patching or handling system and method according to the present invention may thus be described as operable to transmit video data via a cube mapping mechanism, which cube mapping mechanism utilizes six cube faces of a cubic viewpoint for compiling a 360 degree map shape or panorama. The video data associated with each cube face is preferably transmitted intermediate a sending and receiving client via a basal TCP or UDP port and at least one secondary TCP or UDP port. Audio data may be selectively and simultaneously transmitted with the video data, and either appended to a select cube face video transmission as at cube face or frame 41' or transmitted in parallel to the video data via a dedicated basal and secondary TCP or UDP multi-port set as at 43.

Accordingly, although the inventive system and method have been described by reference to a number of varying exemplary systems and methodologies, it is not intended that the data handling and transmission systems and methods be limited thereby, but that modifications thereof are intended to be included as falling within the scope of the present invention as defined by the appended claims.

## Claims

1. A data handling system operable within a computing environment for reducing data redundancy within data storage, the data handling system comprising a data storage (20) and a non-transitory, computer-implementable data comparison application, the non-transitory, computer-implementable data comparison application being operable to:
(c) identify an optimal base file (24) by calculating data difference files (15) between a first data file (11) and possible base file (24) candidates;
and wherein identifying an optimal base file (24) further comprises:
(c1) comparing (115) the size of each calculated data difference file (15) to a threshold value:
(c2) if all data difference file (15) sizes exceed the threshold value, the first data file (11) is stored (116) as a new base file (24) in the data storage (20), if one or more data difference file (15) sizes are below the threshold value, the data difference file (15) of least value is stored within the data storage (20) for reducing data redundancy therein and the first data file (11) is deleted (117);
**characterised in that** the data handling system is a Pulse Code Modulation (PCM) data handling system and the first data file (11) is a first PCM data file (11), the non-transitory, computer-implementable data comparison application being operable, before step (c), to:
(a) generate (113) a fingerprint of the first PCM data file (11) with a media or audio file fingerprinting mechanism; and
(b) map (114) the generated fingerprint of the first PCM data file (11) to the possible base file (24) candidates, where the possible base file (24) candidates have fingerprints similar to the fingerprint of the first PCM data file (11).

2. The system of claim 1 **characterised in that** the system comprises a non-transitory, computer-implementable data restoration application, the non-transitory, computer-implementable data restoration application being operable to losslessly reproduce a select data file from the group consisting of the first PCM data file (11) and a second PCM data file (12) via one of the stored base files (24) and a data difference file (15) corresponding to the select data file (15).

3. The system of claim 2 **characterised in that** the non-transitory, computer-implementable data restoration application is operable to losslessly reproduce (108) (a) the first PCM data file (11) via input (i) compressed second file data (22) of the stored base files (24) and (ii) the data difference file (15) corresponding to the first PCM data file (11), and (b) the second PCM data file (12) via input (i) compressed input first file data (23) of the stored base files (24) and (ii) the data difference file (15) corresponding to the second PCM data file (12).

4. The system of claim 2 **characterised in that** lossless restoration of the select data file (15) is initiated via a requesting client (25) by requesting (111) the select data file (15) from the data storage (20); a base data file (24) and the data difference file (15) corresponding to the select data file (15) together being returned (112) to the requesting client (25) from the data storage (20); and restoration data of the requested select data file (15) being re-produced at the requesting client (25) via the computer-implemented, non-transitory data restoration application.

5. The system of claim 4 **characterised in that** the data difference file (15) corresponding to the select data file (15) is fragmented and delivered to the requesting client (25) incrementally to incrementally patch the select data file (15) while being re-produced.

6. The system of claim 4 **characterised in that** restoration data is returned in a single binary stream (49) as PCM base data (47) and PCM difference data (48), the PCM base data (47) and the PCM difference data (48) being mixed and delivered in consistent and alternating intervals.

7. The system of claim 4 **characterised in that** file playback is accomplished by decoding (118) a select base file (28) to base file PCM data (29); patching (119) the base file PCM data (29) with the data difference file (15) corresponding to the select data file (15) to form patched PCM data output (30); and sending the patched PCM data output (30) for playback (120) as an original PCM file.

8. The system of claim 4 **characterised in that** file data are transmitted intermediate a sending client (32) and a receiving client (31) via at least two data transmission ports (33,34,35), a basal port (33) of the at least two data transmission ports (33,34,35) being dedicated for base quality data (38) transmission and at least one secondary port (34,35) of the at least two data transmission ports (33,34,35) being dedicated for difference data (36,37) transmission, the base quality data (38) transmission and the difference data (36,37) transmission being synchronized at the receiving client (31) for producing higher than basal quality media (39,30) for playback (120).

9. A data handling method for reducing data redundancy within data storage, the data handling method comprising the steps of:
(c) identifying an optimal base file (24) by calculating data difference files (15) between a first data file (11) and possible base file (24) candidates;
and wherein the step of identifying an optimal base file (24) further comprises:
(c1) comparing (115) the size of each calculated data difference file (15) to a threshold value:
(c2) if all data difference file (15) sizes exceed the threshold value, the first data file (11) is stored (116) as a new base file (24) in the data storage (20), if one or more data difference file (15) sizes are below the threshold value, the data difference file (15) of least value is stored within the data storage (20) for reducing data redundancy therein and the first data file (11) is deleted (117);
**characterised in that** the data handling method is a Pulse Code Modulation (PCM) data handling method and the first data file (11) is a first PCM data file (11), the Pulse Code Modulation (PCM) data handling method further comprising, before step (c), the steps of:
(a) generating (113) a fingerprint of the first PCM data file (11) with a media or audio file fingerprinting mechanism; and
(b) mapping (114) the generated fingerprint of the first PCM data file (11) to possible base file (24) candidates, where possible base file (24) candidates have fingerprints similar to the fingerprint of the first PCM data file (11).

10. The method of claim 9 **characterised in that** the method comprises the steps of:
compressing (106) the data difference file (15) via a computer-implemented, non-transitory data compression application; and
storing (106) the compressed data difference file (15) via the computer-implemented, non-transitory data compression application.

11. The method of claim 10 **characterised in that** the method comprises the step of losslessly restoring a select data file (15) from the group consisting of the first PCM data file (11) and a second PCM data file (12) via one of the stored base files (24) and the compressed data difference file (15) corresponding to the select data file (15) via a computer-implemented, non-transitory data restoration application, the select data file (15) being losslessly restored via the compressed data difference file (15).

12. The method of claim 11 **characterised in that** the step of losslessly restoring the select data file (15) comprises the steps of:
requesting via a requesting client (25) the select data file (15) from data storage (20);
returning a base data file (24) and the compressed data difference file (15) corresponding to the select data file (15) to the requesting client (25) from the data storage (20); and
re-producing data of the requested select data file (15) at the requesting client (25) via the computer-implemented, non-transitory data restoration application.

13. The method of claim 12 **characterised in that** the compressed data difference file (15) corresponding to the select data file (15) is fragmented and delivered to the requesting client (25) incrementally to incrementally patch (119) the select data file (15) while being reproduced.

14. The method of claim 12 **characterised in that** file restoration data is returned in a single binary stream (49) as PCM base data (47) and PCM difference data (48), the PCM base data (47) and the PCM difference data (48) being mixed and delivered in consistent and alternating intervals.

15. The method of claim 9 **characterised in that** the method comprises a file playback process (120), the file playback process (120) comprising a series of playback steps, the series of playback steps comprising the steps of:
decoding (118) a select base file (28) to base file PCM data (29);
patching (119) the base file PCM data (29) with the select data file (15) thereby forming patched PCM data output (30); and
sending the patched PCM data output (30) for playback (120) as original PCM file data.

16. The method of claim 12 **characterised in that** file data are transmitted intermediate a sending client (32) and a receiving client (31) via at least two data transmission ports (33,34,35), a basal port (33) of the at least two data transmission ports (33,34,35) being dedicated for base quality data (38) transmission and at least one secondary port (34,35) of the at least two data transmission ports (33,34,35) being dedicated for difference data (36,37) transmission, base quality data (38) and difference data (36,37) transmissions being synchronized at the receiving client (31) for producing higher than basal quality media (39,30) for playback (120).

## Patentansprüche

1. Datenhandhabungssystem, das in einer Computerumgebung betrieben werden kann, um eine Datenredundanz innerhalb eines Datenspeichers zu reduzieren, wobei das Datenhandhabungssystem einen Datenspeicher (20) und eine nicht-transitorische, computer-implementierbare Datenvergleichsanwendung umfasst, wobei die nicht-transitorische, computer-implementierbare Datenvergleichsanwendung betreibbar ist zum:
(c) Identifizieren einer optimalen Basisdatei (24) durch Berechnung von Datendifferenzdateien (15) zwischen einer ersten Datendatei (11) und möglichen Basisdatei (24)-Kandidaten;
und wobei das Identifizieren einer optimalen Basisdatei (24) ferner umfasst:
(c1) Vergleichen (115) der Größe jeder berechneten Datendifferenzdatei (15) mit einem Schwellenwert;
(c2) wenn alle Größen der Datendifferenzdatei (15) den Schwellenwert überschreiten, wird die erste Datendatei (11) als neue Basisdatei (24) im Datenspeicher (20) gespeichert (116), wenn die Größen einer oder mehrerer Datendifferenzdateien (15) unter dem Schwellenwert liegen, wird die Datendifferenzdatei (15) des kleinsten Wertes im Datenspeicher (20) gespeichert zur Reduzierung der Datenredundanz darin und die erste Datendatei (11) wird gelöscht (117);
**dadurch gekennzeichnet, dass** das Datenhandhabungssystem ein Puls-Code-Modulations- (PCM-) Datenhandhabungssystem ist und die erste Datendatei (11) eine erste PCM-Datendatei (11) ist, wobei die nicht-transitorische, computer-implementierbare Datenvergleichsanwendung vor Schritt (c) betreibbar ist zum:
(a) Erzeugen (113) eines Fingerabdrucks der ersten PCM-Datendatei (11) mit einem Medium oder Mechanismus zum Fingerabdruck-Drucken von Audiodateien; und
(b) Zuordnen (114) des erzeugten Fingerabdrucks der ersten PCM-Datendatei (11) zu den möglichen Basisdatei (24)-Kandidaten, wo die möglichen Basisdatei (24)-Kandidaten Fingerabdrücke haben, die dem Fingerabdruck der ersten PCM-Datendatei (11) ähneln.

2. System nach Anspruch 1, **dadurch gekennzeichnet, dass** das System eine nicht-transitorische, computer-implementierbare Datenwiederherstellungsanwendung umfasst, wobei die nicht-transitorische, computer-implementierbare Datenwiederherstellungsanwendung betreibbar ist zur verlustfreien Reproduktion einer ausgewählten Datendatei aus der Gruppe bestehend aus der ersten PCM-Datendatei (11) und einer zweiten PCM-Datendatei (12) über eine der gespeicherten Basisdateien (24) und eine Datendifferenzdatei (15), die der ausgewählten Datendatei (15) entspricht.

3. System nach Anspruch 2, **dadurch gekennzeichnet, dass** die nicht-transitorische, computer-implementierbare Datenwiederherstellungsanwendung betreibbar ist zur verlustfreien Reproduktion (108) (a) der ersten PCM-Datendatei (11) über eine Eingabe (i) komprimierter zweiter Dateidaten (22) der gespeicherten Basisdateien (24) und (ii) der Datendifferenzdatei (15), die der ersten PCM-Datendatei (11) entspricht, und (b) der zweiten PCM-Datendatei (12) über eine Eingabe (i) komprimierte Eingangsdaten der ersten Datei (23) der gespeicherten Basisdateien (24) und (ii) der Datendifferenzdatei (15), die der zweiten PCM-Datendatei (12) entspricht.

4. System nach Anspruch 2, **dadurch gekennzeichnet, dass** eine verlustfreie Wiederherstellung der ausgewählten Datendatei (15) über einen anfragenden Client (25) durch Anfragen (111) der ausgewählten Datendatei (15) aus dem Datenspeicher (20) initiiert wird; eine Basisdatendatei (24) und die Datendifferenzdatei (15), die der ausgewählten Datendatei (15) zusammen an den anfragenden Client (25) vom Datenspeicher (20) zurückgegeben (112) wird; und Wiederherstellungsdaten der angefragten ausgewählten Datendatei (15) am anfragenden Client (25) über die computer-implementierte, nicht-transitorische Datenwiederherstellungsanwendung reproduziert werden.

5. System nach Anspruch 4, **dadurch gekennzeichnet, dass** die Datendifferenzdatei (15), die der ausgewählten Datendatei (15) entspricht, fragmentiert und inkrementell an den anfragenden Client (25) geliefert wird, um die ausgewählte Datendatei (15) während der Reproduktion inkrementell zu patchen.

6. System nach Anspruch 4, **dadurch gekennzeichnet, dass** die Wiederherstellungsdaten in einem einzigen Binärstrom (49) zurückgegeben werden als PCM-Basisdaten (47) und PCM-Differenzdaten (48), wobei die PCM-Basisdaten (47) und die PCM-Differenzdaten (48) gemischt und in konsistenten und abwechselnden Intervallen geliefert werden.

7. System nach Anspruch 4, **dadurch gekennzeichnet, dass** eine Dateiwiedergabe durch Dekodierung (118) einer ausgewählten Basisdatei (28) zu Basisdatei-PCM-Daten (29) erreicht wird; Patchen (119) der Basisdatei-PCM-Daten (29) mit der Datendifferenzdatei (15), die der ausgewählten Datendatei (15) entspricht, um eine gepatchte PCM-Datenausgabe (30) zu bilden; und Senden der gepatchten PCM-Datenausgabe (30) zur Wiedergabe (120) als eine originale PCM-Datei.

8. System nach Anspruch 4, **dadurch gekennzeichnet, dass** die Dateidaten zwischen einem Sendeclient (32) und einem Empfangsclient (31) über mindestens zwei Datenübertragungsports (33, 34, 35) übertragen werden, wobei ein Basisport (33) der mindestens zwei Datenübertragungsports (33, 34, 35) für eine Übertragung von Basisqualitätsdaten (38) bestimmt ist und mindestens ein sekundärer Port (34, 35) der mindestens zwei Datenübertragungsports (33, 34, 35) für eine Übertragung von Differenzdaten (36, 37) bestimmt ist, wobei die Übertragung von Basisqualitätsdaten (38) und die Übertragung von Differenzdaten (36, 37) am Empfangsclient (31) synchronisiert werden, um Medien (39, 30) von höherer als grundlegender Qualität für die Wiedergabe (120) zu produzieren.

9. Datenhandhabungsverfahren zur Reduzierung der Datenredundanz innerhalb eines Datenspeichers, wobei das Datenhandhabungsverfahren die folgenden Schritte umfasst:
(c) Identifizieren einer optimalen Basisdatei (24) durch Berechnung von Datendifferenzdateien (15) zwischen einer ersten Datendatei (11) und möglichen Basisdatei (24)-Kandidaten;
und wobei der Schritt des Identifizierens einer optimalen Basisdatei (24) ferner umfasst:
(c1) Vergleichen (115) der Größe jeder berechneten Datendifferenzdatei (15) mit einem Schwellenwert;
(c2) wenn alle Größen der Datendifferenzdatei (15) den Schwellenwert überschreiten, wird die erste Datendatei (11) als neue Basisdatei (24) im Datenspeicher (20) gespeichert (116), wenn die Größen einer oder mehrerer Datendifferenzdateien (15) unter dem Schwellenwert liegen, wird die Datendifferenzdatei (15) des kleinsten Wertes im Datenspeicher (20) gespeichert zur Reduzierung der Datenredundanz darin und die erste Datendatei (11) wird gelöscht (117);
**dadurch gekennzeichnet, dass** das Datenhandhabungsverfahren ein Puls-Code- Modulations- (PCM-) Datenhandhabungsverfahren ist und die erste Datendatei (11) eine erste PCM-Datendatei (11) ist, wobei das Puls-Code- Modulations- (PCM-) Datenhandhabungsverfahren ferner vor Schritt (c) die Schritte umfasst:
(a) Erzeugen (113) eines Fingerabdrucks der ersten PCM-Datendatei (11) mit einem Medium oder Mechanismus zum Fingerabdruck-Drucken von Audiodateien; und
(b) Zuordnen (114) des erzeugten Fingerabdrucks der ersten PCM-Datendatei (11) zu den möglichen Basisdatei (24)-Kandidaten, wo die möglichen Basisdatei (24)-Kandidaten Fingerabdrücke haben, die dem Fingerabdruck der ersten PCM-Datendatei (11) ähneln.

10. Verfahren nach Anspruch 9, **dadurch gekennzeichnet, dass** das Verfahren die folgenden Schritte umfasst:
Komprimieren (106) der Datendifferenzdatei (15) durch eine computer-implementierte, nicht-transitorische Datenkompressionsanwendung; und
Speichern (106) der komprimierten Datendifferenzdatei (15) durch die computer-implementierte, nicht-transitorische Datenkompressionsanwendung.

11. Verfahren nach Anspruch 10, **dadurch gekennzeichnet, dass** das Verfahren den Schritt einer verlustfreien Wiederherstellung einer ausgewählten Datendatei (15) aus der Gruppe bestehend aus der ersten PCM-Datendatei (11) und
einer zweiten PCM-Datendatei (12) über eine der gespeicherten Basisdateien (24) und der komprimierten Datendifferenzdatei (15), die der ausgewählten Datendatei (15) entspricht, durch eine computer-implementierte, nicht-transitorische Datenwiederherstellungsanwendung umfasst, wobei die ausgewählte Datendatei (15) verlustfrei wiederhergestellt wird über die komprimierte Datendifferenzdatei (15).

12. Verfahren nach Anspruch 11, **dadurch gekennzeichnet, dass** der Schritt der verlustfreien Wiederherstellung der ausgewählten Datendatei (15) die folgenden Schritte umfasst:
über einen anfragenden Client (25) Anfragen der ausgewählten Datendatei (15) aus dem Datenspeicher (20);
Rückgeben einer Basisdatendatei (24) und der komprimierten Datendifferenzdatei (15), die der ausgewählten Datendatei (15) entspricht, an den anfragenden Client (25) aus dem Datenspeicher (20); und
Reproduzieren von Daten der angefragten ausgewählten Datendatei (15) am anfragenden Client (25) über die computer-implementierte, nicht-transitorische Datenwiederherstellungsanwendung.

13. Verfahren nach Anspruch 12, **dadurch gekennzeichnet, dass** die komprimierte Datendifferenzdatei (15), die der ausgewählten Datendatei (15) entspricht, fragmentiert und inkrementell an den anfragenden Client (25) geliefert wird, um die ausgewählte Datendatei (15) inkrementell zu patchen (119), während sie reproduziert wird.

14. Verfahren nach Anspruch 12, **dadurch gekennzeichnet, dass** die Dateiwiederherstellungsdaten in einem einzigen Binärstrom (49) zurückgegeben werden als PCM-Basisdaten (47) und PCM-Differenzdaten (48), wobei die PCM-Basisdaten (47) und die PCM-Differenzdaten (48) gemischt und in konsistenten und abwechselnden Intervallen geliefert werden.

15. Verfahren nach Anspruch 9, **dadurch gekennzeichnet, dass** das Verfahren einen Dateiwiedergabeprozess (120) umfasst, wobei der Dateiwiedergabeprozess (120) eine Reihe von Wiedergabeschritten umfasst, wobei die Reihe von Wiedergabeschritten die folgenden Schritte umfasst:
Dekodieren (118) einer ausgewählten Basisdatei (28) zu Basisdatei-PCM-Daten (29);
Patchen (119) der Basisdatei-PCM-Daten (29) mit der ausgewählten Datendatei (15), wodurch eine gepatchte PCM-Datenausgabe (30) gebildet wird; und
Senden der gepatchten PCM-Datenausgabe (30) zur Wiedergabe (120) als Original-PCM-Dateidaten.

16. Verfahren nach Anspruch 12, **dadurch gekennzeichnet, dass** die Dateidaten zwischen einem Sendeclient (32) und einem Empfangsclient (31) über mindestens zwei Datenübertragungsports (33, 34, 35) übertragen werden, wobei ein Basisport (33) der mindestens zwei Datenübertragungsports (33, 34, 35) für eine Übertragung von Basisqualitätsdaten (38) und mindestens ein sekundärer Port (34, 35) der mindestens zwei Datenübertragungsports (33, 34, 35) für eine Übertragung von Differenzdaten (36, 37) bestimmt sind, wobei Übertragungen von Basisqualitätsdaten (38) und Differenzdaten (36, 37) am Empfangsclient (31) synchronisiert werden, um Medien (39, 30) von höherer als grundlegender Qualität für die Wiedergabe (120) zu produzieren.

## Revendications

1. Système de manipulation de données pouvant être mis en œuvre dans un environnement informatique pour réduire la redondance de données dans un stockage de données, le système de manipulation de données comprenant un stockage de données (20) et une application de comparaison de données non transitoire implémentable par ordinateur, l'application de comparaison de données non transitoire implémentable par ordinateur pouvant être mise en œuvre pour :
(c) l'identification d'un fichier de base optimal (24) en calculant des fichiers de différence de données (15) entre un premier fichier de données (11) et des candidats possibles de fichier de base (24) et dans lequel l'identification d'un fichier de base optimal (24) comprend en outre :
(c1) la comparaison (115) de la taille de chaque fichier de différence de données calculé (15) à une valeur seuil :
(c2) si toutes les tailles de fichier de différence de données (15) dépassent la valeur seuil, le premier fichier de données (11) est stocké (116) en tant que nouveau fichier de base (24) dans le stockage de données (20), si une ou plusieurs tailles de fichier de différence de données (15) sont inférieures à la valeur seuil, le fichier de différence de données (15) de moindre valeur est stocké dans le stockage de données (20) pour réduire la redondance de données dans celui-ci et le premier fichier de données (11) est supprimé (117) ;
**caractérisé en ce que** le système de manipulation de données est un système de manipulation de données à modulation par impulsion et codage (MIC) et le premier fichier de données (11) est un premier fichier de données MIC (11), l'application de la comparaison de données non transitoire implémentable par ordinateur, pouvant fonctionner, avant l'étape (c), pour :
(a) générer (113) une empreinte digitale du premier fichier de données MIC (11) avec un mécanisme d'empreinte digitale de fichier multimédia ou audio ; et
(b) mettre en correspondance (114) l'empreinte digitale générée du premier fichier de données MIC (11) avec les candidats possibles de fichiers de base (24), où les candidats possibles de fichier de base (24) ont des empreintes digitales similaires à l'empreinte digitale du premier fichier de données MIC (11).

2. Système selon la revendication 1, **caractérisé en ce que** le système comprend une application de restauration de données non transitoire implémentable par ordinateur, l'application de restauration de données non transitoire implémentable par ordinateur étant utilisable pour reproduire sans perte un fichier de données sélectionné dans le groupe constitué du premier fichier de données MIC (11) et d'un second fichier de données MIC (12) via l'un des fichiers de base stockés (24) et un fichier de différence de données (15) correspondant au fichier de données sélectionné (15).

3. Système selon la revendication 2, **caractérisé en ce que** l'application de restauration de données non-transitoire implémentable par ordinateur est utilisable pour reproduire sans perte (108) (a) le premier fichier de données MIC (11) via l'entrée (i) de secondes données de fichier compressées (22) des fichiers de base stockés (24) et (ii) du fichier de différence de données (15) correspondant au premier fichier de données MIC (11), et (b) le second fichier de données MIC (12) via l'entrée (i) des premières données de fichier d'entrée compressées (23) des fichiers de base stockés (24) et (ii) du fichier de différence de données (15) correspondant au second fichier de données MIC (12).

4. Système selon la revendication 2, **caractérisé en ce que** la restauration sans perte du fichier de données sélectionné (15) est initiée via un client demandeur (25) en demandant (111) le fichier de données sélectionné (15) à partir du stockage de données (20) ; un fichier de données de base (24) et le fichier de différence de données (15) correspondant au fichier de données sélectionné (15) sont renvoyés ensemble (112) au client demandeur (25) à partir du stockage de données (20) ; et les données de restauration du fichier de données sélectionné demandé (15) sont reproduites au niveau du client demandeur (25) par l'intermédiaire de l'application de restauration de données non transitoire implémentable par ordinateur.

5. Système selon la revendication 4, **caractérisé en ce que** le fichier de différence de données (15) correspondant au fichier de données sélectionné (15) est fragmenté et délivré au client demandeur (25) de manière incrémentielle pour corriger de manière incrémentielle le fichier de données sélectionné (15) tout en étant reproduit.

6. Système selon la revendication 4, **caractérisé en ce que** les données de restauration sont renvoyées dans un seul flux binaire (49) en tant que données de base MIC (47) et données de différence MIC (48), les données de base MIC (47) et les données de différence MIC (48) étant mélangées et délivrées à des intervalles réguliers et alternés.

7. Système selon la revendication 4, **caractérisé en ce que** la lecture de fichier est accomplie en décodant (118) un fichier de base sélectionné (28) en données MIC de fichier de base (29) ; en corrigeant (119) les données MIC de fichier de base (29) avec le fichier de différence de données (15) correspondant au fichier de données sélectionné (15) pour former une sortie de données MIC corrigée (30) ; et en envoyant la sortie de données MIC corrigée (30) pour la lecture (120) comme un fichier MIC original.

8. Système selon la revendication 4 **caractérisé en ce que** les données de fichier sont transmises entre un client émetteur (32) et un client récepteur (31) par l'intermédiaire d'au moins deux ports de transmission de données (33, 34, 35), un port de base (33) des au moins deux ports de transmission de données (33, 34, 35) étant dédié à la transmission de données de qualité de base (38) et au moins un port secondaire (34,35) des au moins deux ports de transmission de données (33, 34, 35) étant dédié à la transmission de données de différence (36, 37), la transmission de données de qualité de base (38) et la transmission de données de différence (36, 37) étant synchronisées au niveau du client récepteur (31) pour produire des supports de qualité supérieure à la qualité de base (39, 30) pour la lecture (120).

9. Procédé selon manipulation de données pour réduire la redondance des données dans un stockage de données, le procédé de manipulation de données comprenant les étapes consistant à :
(c) identifier un fichier de base optimal (24) en calculant des fichiers de différence de données (15) entre un premier fichier de données (11) et des candidats possibles de fichier de base (24) et dans lequel l'étape d'identification d'un fichier de base optimal (24) comprend en outre :
(c1) comparer (115) la taille de chaque fichier de différence de données calculé (15) à une valeur de seuil:
(c2) si toutes les tailles de fichier de différence de données (15) dépassent la valeur seuil, le premier fichier de données (11) est stocké (116) en tant que nouveau fichier de base (24) dans le stockage de données (20), si une ou plusieurs tailles de fichier de différence de données (15) sont inférieures à la valeur seuil, le fichier de différence de données (15) de moindre valeur est stocké dans le stockage de données (20) pour réduire la redondance des données dans celui-ci et le premier fichier de données (11) est supprimé (117) ;
**caractérisé en ce que** le procédé de manipulation de données est un procédé de manipulation des données à modulation par impulsion et codage (MIC) et le premier fichier de données (11) est un premier fichier de données MIC (11), le procédé de manipulation des données à modulation par impulsion et codage (MIC) comprenant en outre, avant l'étape (c), les étapes suivantes
(a) générer (113) une empreinte digitale du premier fichier de données MIC (11) avec un mécanisme d'empreinte digitale de fichier multimédia ou audio ; et
(b) mettre en correspondance (114) l'empreinte digitale générée du premier fichier de données MIC (11) avec des candidats possibles de fichiers de base (24), où les candidats possibles de fichiers de base (24) ont des empreintes digitales similaires à l'empreinte digitale du premier fichier de données MIC (11).

10. Procédé selon la revendication 9, **caractérisé en ce que** le procédé comprend les étapes suivantes :
compresser (106) le fichier de différence de données (15) par l'intermédiaire d'une application de compression de données non transitoire implémentable par ordinateur ; et
stocker (106) le fichier de différence de données compressé (15) par l'intermédiaire de l'application de compression de données non transitoire implémentable par ordinateur.

11. Procédé selon la revendication 10 **caractérisé en ce que** le procédé comprend l'étape de restauration sans perte d'un fichier de données sélectionné (15) à partir du groupe constitué du premier fichier de données MIC (11) et d'un second fichier de données MIC (12) par l'intermédiaire de l'un des fichiers de base stockés (24) et du fichier de différence de données compressé (15) correspondant au fichier de données sélectionné (15) par l'intermédiaire d'une application de restauration de données non transitoire implémentable par ordinateur, le fichier de données sélectionné (15) étant restauré sans perte par le fichier de différence de données compressé (15).

12. Procédé selon la revendication 11, **caractérisé en ce que** l'étape de restauration sans perte du fichier de données sélectionné (15) comprend les étapes suivantes :
demander via un client demandeur (25) le fichier de données sélectionné (15) à partir du stockage de données (20) ;
renvoyer un fichier de données de base (24) et le fichier de différence de données compressé (15) correspondant au fichier de données sélectionné (15) au client demandeur (25) à partir du stockage de données (20) ; et
la reproduction de données du fichier de données sélectionné demandé (15) au niveau du client demandeur (25) par l'intermédiaire de l'application de restauration de données non transitoire implémentable par ordinateur.

13. Procédé selon la revendication 12, **caractérisé en ce que** le fichier de différence de données compressé (15) correspondant au fichier de données sélectionné (15) est fragmenté et délivré au client demandeur (25) de manière incrémentielle pour corriger de manière incrémentielle (119) le fichier de données sélectionné (15) pendant sa reproduction.

14. Procédé selon la revendication 12, **caractérisé en ce que** les données de restauration de fichiers sont renvoyées dans un flux binaire unique (49) en tant que données de base MIC (47) et données de différence MIC ( 48), les données de base MIC (47) et les données de différence MIC ( 48) étant mélangées et délivrées à des intervalles réguliers et alternés.

15. Procédé de la revendication 9, **caractérisé en ce que** le procédé comprend un procédé de lecture de fichier (120), le procédé de lecture de fichier (120) comprenant une série d'étapes de lecture, la série d'étapes de lecture comprenant les étapes suivantes :
décoder (118) un fichier de base sélectionné (28) en données MIC de fichier de base (29) ;
patcher (119) les données MIC du fichier de base (29) avec le fichier de données sélectionné (15), formant ainsi une sortie de données MIC corrigées (30) ; et
envoyer la sortie de données MIC corrigées (30) pour la lecture (120) comme données de fichier MIC originales.

16. Procédé selon la revendication 12, **caractérisé en ce que** les données de fichier sont transmises entre un client émetteur (32) et un client récepteur (31) via au moins deux ports de transmission de données (33, 34, 35), un port de base (33) des au moins deux ports de transmission de données (33, 34, 35) étant dédié à la transmission de données de qualité de base (38) et au moins un port secondaire (34,35) des au moins deux ports de transmission de données (33, 34, 35) étant dédié à la transmission de données de différence (36, 37), les transmissions de données de qualité de base (38) et de données de différence (36, 37) étant synchronisées au niveau du client de réception (31) pour produire des supports de qualité supérieure à la qualité de base (39, 30) pour la lecture (120).
